# EUROPEAN PATENT APPLICATION

(11) **EP 4 800 791 A1**
(43) Date of publication of application: **02.09.2026**
(21) Application number: 26161117.2
(22) Date of filing: 26.02.2026
(51) Int. Cl.: H01M 10/0525, B60L 58/16, G01R 31/367, H01M 10/48

(54) **SYSTEMS AND METHODS FOR COMPUTATIONALLY EFFICIENT LITHIUM PLATING DETECTION**

(30) Priority: 28.02.2025 US 202519067453
(71) Applicant: Eatron Technologies Limited, Warwick CV34 6UW (GB); LG Energy Solution, Ltd., Seoul 07335 (KR)
(72) Inventor: GUNEL, Mustafa Burak, 34408 Istanbul (TR); KURTULUS, Can, 34349 Istanbul (TR); YAVAS, Muharrem Ugur, 34742 Istanbul (TR); PARK, Junsik, 34114 Daejeon (KR); BYUN, Haeun, 34114 Daejeon (KR)
(74) Representative: Cobbold, Alistair John

(57) **Abstract**

In one aspect, a computer-implemented method may include receiving, at edge processing devices, measurements from sensors associated with a battery pack. The computer-implemented method may include processing, at the edge processing devices, the measurements using a data profiler to generate data profiles including e voltage values, transforming, at the edge processing devices, the voltage values to generate transformed voltage values, determining, at the edge processing devices using the voltage values and the transformed voltage values, features, and determining, using trained edge computer-implemented models, a lithium plating occurrence prediction of the battery pack. The computer-implemented method may include modifying, using the lithium plating occurrence prediction, operation of the battery pack.

## Description

### TECHNICAL FIELD

This disclosure relates generally to assets and batteries. More specifically, this disclosure relates to systems and methods for computationally efficient lithium plating detection in assets and batteries.

### BACKGROUND

Lithium-ion batteries (LIBs) have become a ubiquitous power source for a wide range of applications, from portable electronics to electric vehicles and grid storage solutions. Their high energy density, long cycle life, and declining cost have driven widespread adoption. However, one of the critical challenges affecting the performance of LIBs is the phenomenon of lithium plating.

Lithium plating refers to the deposition of metallic lithium on the anode surface during the charging process. Ideally, lithium ions should intercalate into the anode material (commonly graphite) during charging and de-intercalate during discharging. However, under certain conditions, instead of intercalating, lithium ions deposit as metallic lithium. This can occur when the charging current is too high, the temperature is too low.

Lithium plating may occur when the anode potential drops below the reduction potential of lithium (around 0 V vs. Li/Li+). This condition can arise under high-rate charging, where the rapid influx of lithium ions exceeds the intercalation capacity of the graphite anode. It can also occur at low temperatures due to reduced lithium-ion mobility and increased electrolyte resistance. The plating process is governed by factors such as current density, temperature, electrolyte composition.

### SUMMARY

In one aspect, a computer-implemented method may include receiving, at one or more edge processing devices, one or more measurements from one or more sensors associated with a battery pack. The computer-implemented method may include processing, at the one or more edge processing devices, the one or more measurements using a data profiler to generate one or more data profiles including one or more voltage values, transforming, at the one or more edge processing devices, the one or more voltage values to generate one or more transformed voltage values, determining, at the one or more edge processing devices using the one or more voltage values and the one or more transformed voltage values, one or more features, and determining, using one or more trained edge computer-implemented models, a lithium plating occurrence prediction of the battery pack. The one or more trained edge computer-implemented models determines the lithium plating occurrence prediction based at least on one or more uncertainties for the one or more features and one or more explanations for the one or more uncertainties. The computer-implemented method may include modifying, using the lithium plating occurrence prediction, operation of the battery pack.

In another aspect, a tangible, non-transitory computer-readable medium may store instructions and a processing device may execute the instructions to perform one or more operations of any method disclosed herein.

In another aspect, a method may include one or more operations implemented by computer instructions and performed by one or more processing devices to perform the techniques disclosed herein.

Other technical features may be readily apparent to one skilled in the art from the following figures, descriptions, and claims.

Before undertaking the DETAILED DESCRIPTION below, it may be advantageous to set forth definitions of certain words and phrases used throughout this patent document. The term "couple" and its derivatives refer to any direct or indirect communication between two or more elements, independent of whether those elements are in physical contact with one another. The terms "transmit," "receive," and "communicate," as well as derivatives thereof, encompass both direct and indirect communication. The terms "transmit," "receive," and "communicate," as well as derivatives thereof, encompass both communication with remote systems and communication within a system, including reading and writing to different portions of a memory device. The terms "include" and "comprise," as well as derivatives thereof, mean inclusion without limitation. The term "or" is inclusive, meaning or. The phrase "associated with," as well as derivatives thereof, means to include, be included within, interconnect with, contain, be contained within, connect to or with, couple to or with, be communicable with, cooperate with, interleave, juxtapose, be proximate to, be bound to or with, have, have a property of, have a relationship to or with, or the like. The term "translate" may refer to any operation performed wherein data is input in one format, representation, language (computer, purpose-specific, such as drug design or integrated circuit design), structure, appearance or other written, oral or representable instantiation and data is output in a different format, representation, language (computer, purpose-specific, such as drug design or integrated circuit design), structure, appearance or other written, oral or representable instantiation, wherein the data output has a similar or identical meaning, semantically or otherwise, to the data input. Translation as a process includes but is not limited to substitution (including macro substitution), encryption, hashing, encoding, decoding or other mathematical or other operations performed on the input data. The same means of translation performed on the same input data will consistently yield the same output data, while a different means of translation performed on the same input data may yield different output data which nevertheless preserves all or part of the meaning or function of the input data, for a given purpose. Notwithstanding the foregoing, in a mathematically degenerate case, a translation can output data identical to the input data. The term "controller" means any device, system or part thereof that controls at least one operation. Such a controller may be implemented in hardware or a combination of hardware and software or firmware. The functionality associated with any particular controller may be centralized or distributed, whether locally or remotely. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

Moreover, various functions described below can be implemented or supported by one or more computer programs, each of which is formed from computer readable program code and embodied in a computer readable storage medium. The terms "application" and "program" refer to one or more computer programs, software components, sets of instructions, procedures, functions, objects, classes, instances, related data, or a portion thereof adapted for implementation in a suitable computer readable program code. The phrase "computer readable program code" includes any type of computer code, including source code, object code, and executable code. The phrase "computer readable storage medium" includes any type of medium capable of being accessed by a computer, such as read only memory (ROM), random access memory (RAM), a hard disk drive, a compact disc (CD), a digital video disc (DVD), solid state drive (SSD), or any other type of memory. A "non-transitory" computer readable storage medium excludes wired, wireless, optical, or other communication links that transport transitory electrical or other signals. A non-transitory computer readable storage medium includes media where data can be permanently stored and media where data can be stored and later overwritten, such as a rewritable optical disc or an erasable memory device.

Definitions for other certain words and phrases are provided throughout this patent document. Those of ordinary skill in the art should understand that in many if not most instances, such definitions apply to prior as well as future uses of such defined words and phrases.

### BRIEF DESCRIPTION OF THE DRAWINGS

For a more complete understanding of this disclosure and its advantages, reference is now made to the following description, taken in conjunction with the accompanying drawings, in which:
FIGURE 1 illustrates a high-level component diagram of an illustrative system architecture according to certain embodiments of this disclosure;
FIGURE 2 illustrates example operations of a method for using one or more computer-implemented models to predict one or more occurrences of lithium plating according to certain embodiments of this disclosure;
FIGURE 3 illustrates an example architecture of using one or more computer-implemented models to predict one or more occurrences of lithium plating and performing one or more actions according to certain embodiments of this disclosure;
FIGURE 4 illustrates profile example graphs of voltage and current according to certain embodiments of this disclosure;
FIGURE 5 illustrates an example of a sampling process according to certain embodiments of this disclosure;
FIGURE 6 illustrates an example graph of individual score contributions of each feature according to certain embodiments of this disclosure;
FIGURE 7 illustrates a value verse score graph of an example feature according to certain embodiments of this disclosure;
FIGURE 8 illustrates a value verse score table of an example feature according to certain embodiments of this disclosure;
FIGURE 9 illustrates a value verse score graph of example combined features according to certain embodiments of this disclosure;
FIGURE 10 illustrates a value verse score table of example combined features according to certain embodiments of this disclosure;
FIGURE 11 illustrates density and score verse value for an example feature according to certain embodiments of this disclosure;
FIGURE 12 illustrates example feature impact scores according to certain embodiments of this disclosure;
FIGURE 13 illustrates an example computer system according to certain embodiments of this disclosure.

### DETAILED DESCRIPTION

Under ideal conditions, the charge-transfer process of Li-ion batteries may include three steps: (i) de-solvation of solvated Li+ ions (Li+ ions lies within a solution, in order to change location, they separate from the solution and penetrate the Solid Electrolyte Interphase (SEI) as a particle, (ii) Li+ ions pass through the SEI, and (iii) solid-state lithium diffuses into graphite particles. At high charging C rate, Li+ ions move fast and a large amount of Li+ ions may accumulate at the electrode interface due to the slow lithium solid diffusion, and lithium plating occurs.

There are certain consequences that may result from lithium plating. For example, the formation of metallic lithium can lead to dendrite growth-needle-like structures that can pierce the separator and cause internal short circuits. Further, lithium plating is typically irreversible, meaning the plated lithium is no longer available for intercalation in subsequent cycles. This may lead to a loss in the battery's capacity and may reduce its overall lifespan. Further, plated lithium can react with the electrolytes to form a solid electrolyte interphase (SEI) layer, consuming active lithium and increasing the internal resistance of the battery. This may reduce the coulombic efficiency and overall performance.

Lithium plating may be determined by tearing down the battery and applying visual inspection on the internal structure of the cell. The deposited lithium may be visible as a thin layer of metallic lithium on the surface of the negative electrode. Another way to detect lithium plating is to use a specialized instrument referred to as a scanning electron microscope. This instrument may produce high-resolution images of the battery's internal structure, allowing the deposited lithium to be seen on the surface of the negative electrode.

A battery pack may consist of different cell modules which include several number of battery cells. The cell modules may be tightly packed such that it is very difficult to individually replace. In some embodiments of the present disclosure, one or more robots may be used to replace faulty or suspicious cell modules including one or more battery cells. In some embodiments, the individual battery cells may be replaced. For example, a fault or suspicious cell may be detected using the disclosed techniques, a driver may drive a vehicle into a service center, the suspected cell may be replaced with a new cell, and the driver may drive the vehicle away. The suspected cell may be sent to a lab for analysis. The lab may determine whether the suspected cell represents a false positive or true positive and the findings may be used as fleet data, which may be used to further train one or more computer-implemented models to classify lithium plating on battery packs.

In some embodiments, the disclosed subject matter provides a technical solution to a technical problem of detecting lithium plating that occurs with one or more batteries. Some embodiments use a supervised learning method as a technical solution to the lithium plating detection problem. The proposed solution may be applied to different kinds of batteries, whether they are big or small, such as smartphones or electric vehicle batteries. The disclosed embodiments may be applicable to full battery pack replacement and/or individual battery cell replacement. Total replacement of a battery pack may be very expensive and may be undesirable to a manufacturer. Thus, the disclosed techniques may enable diagnosing battery cells individually within a battery pack and may enable replacing those individually diagnosed cells and/or changing those individually diagnosed cells. Further, the disclosed techniques may provide a technical solution by actively controlling operation of the battery pack, charger, and/or vehicle based on detected occurrence of lithium plating.

In some embodiments, the disclosed techniques may provide tailored computer-implemented models (e.g., machine learning models) that generate explanations which can be directly used as a feedback to modify charging profile of a battery for prevention of lithium plating. Further, some embodiments may use the computer-implemented models to provide confidence of each lithium plating occurrence prediction, which may prevent false recalls for fleet owners and/or reduce servicing costs.

In addition, some of the calculations which are used to execute the computer-implemented model may be computationally expensive (e.g., fast Fourier transform). This makes it extremely hard to detect lithium plating when computing power is limited, and may pose a technical problem. Typically, electric vehicles, mobile phones, and other battery powered domestic devices have limited processing power. In some embodiments, the disclose techniques may provide a technical solution by intelligently average signals while retaining its original information and significantly reduce processing power / consumption and memory requirements / consumption.

One goal of the disclosed embodiments is to detect lithium plating prior to an undesired event occurring (e.g., short circuit). In some embodiments, when lithium plating occurs, one or more preventative actions may be performed. For example, a processing device may transmit a message to a computing device of a driver to warn the driver to replace the battery cell and/or battery pack when lithium plating is detected. Further, fleet data may be used to improve the accuracy of the proposed embodiments for detecting lithium plating on a particular vehicle. In addition, operation of the battery pack and/or vehicle may be controlled via one or more edge processing devices and/or cloud-based processing devices.

Some embodiments of this disclosure significantly reduces the memory and processing footprint of a lithium plating detection computer-implemented model to execute on many devices that are powered with Li-Ion batteries. Some embodiments make it possible to execute lithium plating detection on small mobile devices such phones, small domestic appliances, smaller electric vehicles.

Some embodiments use Explainable Boosting Machine (EBM), glass-box machine learning technology to charging of battery packs. Some embodiments use lightweight machine learning on the edge and more computationally rigorous machine learning (and retraining) in the cloud making it practically possible to deploy the system. Some embodiments use EBM, glass-box models to provide explainability, which may lead to prevent lithium plating before it occurs by modifying charging behavior of a device.

Further, some embodiments use continuous learning, improving accuracy of prevention as time goes by. For a given battery chemistry, this approach may eradicate lithium plating. In some instances, some embodiments may enable fast charging safely for years longer than standard approaches.

Some embodiments may apply to existing Li-ion battery technologies. Some embodiments may be used in any other industry that relies on rechargeable batteries. Examples include electric vehicles, consumer electronics, renewable energy storage, and personal devices like laptops, mobile phones, electronic watches, rings, and other wearable computing devices. Especially with improvements on its robustness and memory footprint, it is possible to run the disclosed embodiments on a wide range of devices that is powered on with low powered chips.

The utilities and/or benefits of this disclosure may relate to improving the performance, efficiency, and longevity of batteries, which can have significant technical, economic, environmental, and social benefits.

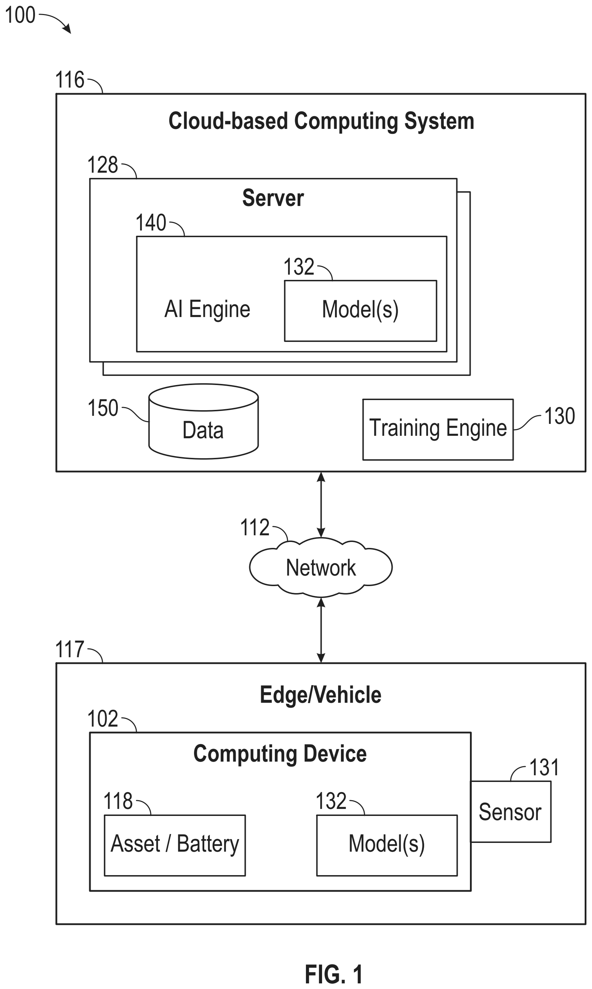

FIGURES 1 through 13, discussed below, and the various embodiments used to describe the principles of this disclosure are by way of illustration only and should not be construed in any way to limit the scope of the disclosure.

FIGURE 1 illustrates a high-level component diagram of an illustrative system architecture 100 according to certain embodiments of this disclosure. In some embodiments, the system architecture 100 may include a cloud-based computing system 116, a computing device 102, and a vehicle 117 communicatively coupled via a network 112. The cloud-based computing system 116 may be a real-time software platform, include privacy software or protocols, or include security software or protocols. Each of the computing device 102 and components included in the cloud-based computing system 116 may include one or more processing devices, memory devices, or network interface cards. The network interface cards may enable communication via a wireless protocol for transmitting data over short distances, such as Bluetooth, ZigBee, NFC, etc. Additionally, the network interface cards may enable communicating data via a wired protocol over short or long distances, and in one example, the computing device 102 and/or the cloud-based computing system 116 may communicate with the network 112. Network 112 may be a public network (e.g., connected to the Internet via wired (Ethernet) or wireless (WiFi)), a private network (e.g., a local area network (LAN) or wide area network (WAN)), or a combination thereof. In some embodiments, network 112 may also comprise a node or nodes on the Internet of Things (IoT).

The computing device 102 may be any suitable computing device, such as an embedded computer device with display, a laptop, tablet, smartphone, headset, wearable, or computer. The computing device 102 may be included within a vehicle, such as an electric vehicle. The computing device 102 may include a display capable of presenting a user interface of an application. The application may be implemented in computer instructions stored on the one or more memory devices of the computing device 102 and executable by the one or more processing devices (e.g., edge processing devices) of the computing device 102. The computing device may include an asset and/or battery pack 118, each of which may have a useful life that degrades over time. The asset and/or battery pack 118 may be used to charge and power a vehicle (e.g., electric vehicle), smartphone, appliance, or any suitable device that uses a battery. The asset and/or battery pack 118 may be separate from or integrated with the computing device 102 within the vehicle 117. The asset and/or battery pack 118 may be communicatively coupled to the computing device 102 and one or more devices of the vehicle 117.

The user interface may present various screens to a user that present various views including notifications of when lithium plating is detected for one or more battery cells and/or one or more battery packs. The user interface may enable performing a preventive action such as presenting a signal (e.g., warning signal that the lithium plating is present) and/or changing an operating parameter of the vehicle to consume less energy from the battery, and the like. The computing device 102 may also include instructions stored on the one or more memory devices that, when executed by the one or more processing devices of the computing device 102, perform operations of any of the methods described herein.

The vehicle 117 may be any suitable type of vehicle or electric vehicle, such as an automobile, a motorcycle, a boat, an airplane, a bicycle, a scooter, a skateboard, roller skates, roller blades, a unicycle, a surfboard, a drone, or the like. Accordingly, the vehicle 117 may include an engine that is powered by one or more batteries, assets, and motors. The vehicle 117 may also include one or more sensors 131 that are configured to measure any suitable parameter of a vehicle (e.g., a temperature of the vehicle 117, a vibration of the vehicle 117, etc.), a battery cell (e.g., a battery cell voltage, a battery cell temperature, a battery cell current, a battery cell capacitance, a battery cell resistance, etc.), a battery module (e.g., a battery module voltage, a battery module current, a battery module temperature, a battery module capacitance, a battery module resistance, etc.), a battery pack (e.g., a battery pack voltage, a battery pack current, a battery pack temperature, a battery pack capacitance, a battery pack resistance, etc.), and the like. The sensors 131 may include an accelerometer, a current sensor, a voltage sensor, a temperature sensor, a thermal sensor, a camera, a capacitance sensor, a resistance sensor, a pressure senor, or the like. The processing device of the vehicle 117 may receive the measurements from the one or more sensors 131 and transmit them via the network 112 to the cloud-based computing system 116 for use in training one or more computer-implemented models 132 (e.g., machine learning models, neural networks, expert systems, etc.). In some embodiments, when a computer-implemented model is trained and ready to process real-time data, the processing device of the vehicle 117 may receive the measurements from the one or more sensors 131 and use them, along with other data (e.g., a user battery usage profile), to predict lithium plating of the battery pack and/or asset 118. The vehicle 117 may also execute an instance of a computer-implemented model 132 that is trained using parameters received from a cloud-based computer-implemented model 132.

The processing device of the vehicle 117 may be included in a control system of the vehicle or the computing device 102. In some embodiments, the computing device 102 is the control system of the vehicle 117. The processing device of the vehicle 117 or the computing device 102 may be referred to as an edge processing device herein.

In some embodiments, the cloud-based computing system 116 may include one or more servers 128 that form a distributed computing system, which may include a cloud computing system. The servers 128 may be a rackmount server, a router, a personal computer, a portable digital assistant, a mobile phone, a laptop computer, a tablet computer, a camera, a video camera, a netbook, a desktop computer, a media center, any other device capable of functioning as a server, or any combination of the above. Each of the servers 128 may include one or more processing devices, memory devices, data storage, or network interface cards. The memory devices of the servers 128 may store instructions implementing one or more software applications that, when executed by one or more processing devices of the servers 128, perform the techniques and methodologies described herein. The servers 128 may be in communication with one another via any suitable communication protocol. The servers 128 may execute an artificial intelligence engine 140 and/or one or more computer-implemented models 132, as described further herein.

That is, the servers 128 may execute an artificial intelligence (AI) engine 140 that uses and/or executes one or more computer-implemented models 132 to perform at least one of the embodiments disclosed herein. The artificial intelligence engine 140 may be implemented in computer instructions stored on one or more memory devices and executed by one or more processing devices. The cloud-based computing system 116 may also include a database 150 that stores data, knowledge, and data structures used to perform various embodiments. For example, the database 150 may store fleet of electric vehicles' data, battery data (e.g., original anode thickness, expected cycle loss, etc.) received from a manufacturer of the battery, lab experiment data pertaining to the battery, user battery usage profile, etc. Although depicted separately from the server 128, in some embodiments, the database 150 may be hosted on one or more of the servers 128.

In some embodiments, the cloud-based computing system 116 may include a training engine 130 capable of generating one or more computer-implemented models 132. Although depicted separately from the AI engine 140, the training engine 130 may, in some embodiments, be included in the AI engine 140 executing on the server 128. In some embodiments, the AI engine 140 may use the training engine 130 to generate the computer-implemented models 132 trained to perform inferencing and/or predicting operations. In some embodiments, computer-implemented models 132 may be implemented on and executed by one or more processing devices of the computing device 102. The computer-implemented models 132 may be trained to predict lithium plating occurrence, among other things. The one or more m computer-implemented models 132 may be generated by the training engine 130 and may be implemented in computer instructions executable by one or more processing devices of the training engine 130 or the servers 128. To generate the one or more computer-implemented models 132, the training engine 130 may train the one or more computer-implemented models 132. The one or more computer-implemented models 132 may be used by any of the methods described herein.

The training engine 130 may be a rackmount server, a router, a personal computer, a portable digital assistant, a smartphone, a laptop computer, a tablet computer, a netbook, a desktop computer, an Internet of Things (IoT) device, any other desired computing device, or any combination of the above. The training engine 130 may be cloud-based, be a real-time software platform, include privacy software or protocols, or include security software or protocols.

To generate the one or more computer-implemented models 132, the training engine 130 may train the one or more computer-implemented models 132. The training engine 130 may use a base training data set including inputs of labeled data (e.g., assigned a value of 1) associated with lithium plating and labeled data (e.g., assigned a value of 0) not associated with lithium plating, among other things. One or more combinations of the inputs may be mapped to an output pertaining to an occurrence of lithium plating of each cell of the battery pack. The training data may be based on features such as voltage values over a period of time (i.e., a voltage profile), or a fast Fourier transform of the voltage values to transform into the frequency domain. For example, the features may include charging voltage profiles, rest voltage profiles, discharging voltage profiles, etc. and/or fast Fourier transforms thereof. Other features can be combinations of voltage values, or a FFT thereof, with voltage values from other periods of time (i.e. other voltage profiles from the same battery cell or battery pack), or a FFT thereof. The features may be derived from measurements taken from a battery cell or battery pack which was then analyzed for the presence of lithium plating, such as by tearing down the battery cell or pack and visual inspecting the internal structure of the cell (or cells), or by imaging using a scanning electron microscope.

The one or more computer-implemented models 132 may refer to model artifacts created by the training engine 130 using training data that includes training inputs and corresponding target outputs. The training engine 130 may find patterns in the training data wherein such patterns map the training input to the target output and generate the computer-implemented models 132 that capture these patterns. Although depicted separately from the server 128, in some embodiments, the training engine 130 may reside on server 128. Further, in some embodiments, the artificial intelligence engine 140, the database 150, or the training engine 130 may reside on the computing device 102.

As described in more detail below, the one or more computer-implemented models 132 may comprise, e.g., a single level of linear or non-linear operations (e.g., a support vector machine (SVM) or the computer-implemented models 132 may be a deep network, i.e., a machine learning model comprising multiple levels of non-linear operations. Examples of deep networks are neural networks, including generative adversarial networks, convolutional neural networks, recurrent neural networks with one or more hidden layers, and fully connected neural networks (e.g., each artificial neuron may transmit its output signal to the input of the remaining neurons, as well as to itself). For example, the machine learning model may include numerous layers or hidden layers that perform calculations (e.g., dot products) using various neurons. In some embodiments, the one or more computer-implemented models 132 may be trained via supervised learning, unsupervised learning, and/or reinforcement learning.

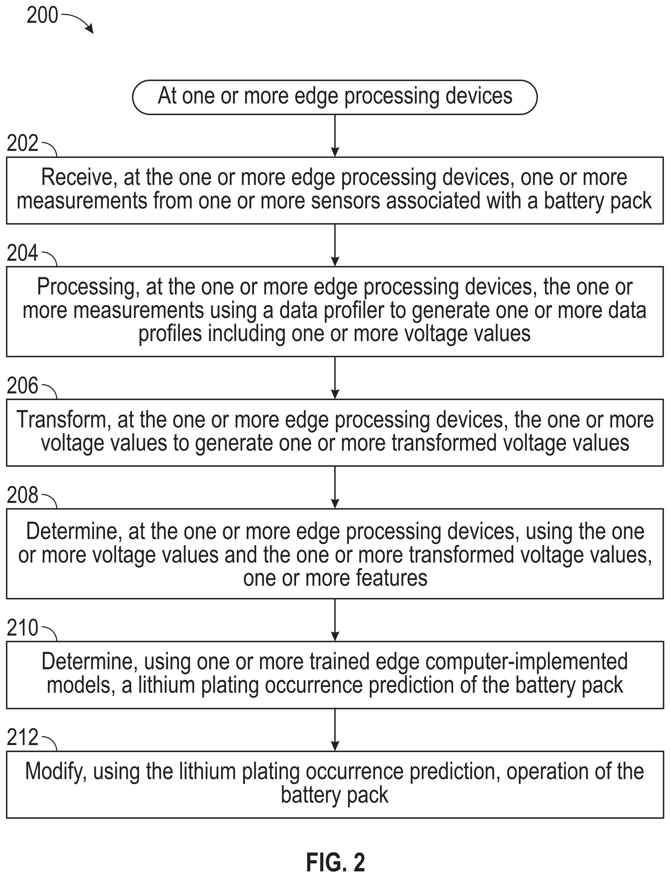

FIGURE 2 illustrates example operations of a method 200 for using one or more computer-implemented models to predict one or more occurrences of lithium plating according to certain embodiments of this disclosure. The method 200 is performed by processing logic that may include hardware (circuitry, dedicated logic, etc.), software (such as is run on a computer system or specialized dedicated machine), or a combination of both. The method 200 or each of their individual functions, routines, subroutines, or operations may be performed by one or more processors of a computing device (e.g., any component of FIGURE 1, such as computing device 102, server 128 executing the artificial intelligence engine 140, etc.). In certain implementations, the method 200 may be performed by a single processing thread. Alternatively, the method 200 may be performed by two or more processing threads, each thread implementing one or more individual functions, routines, subroutines, or operations of the methods. In some embodiments, one or more accelerators may be used to increase the performance of a processing device by offloading various functions, routines, subroutines, or operations from the processing device. One or more operations of the method 200 may be performed by the training engine 130 of FIGURE 1.

For simplicity of explanation, the method 200 is depicted and described as a series of operations. However, operations in accordance with this disclosure can occur in various orders or concurrently, and with other operations not presented and described herein. For example, the operations depicted in the method 200 may occur in combination with any other operation of any other method disclosed herein. Furthermore, not all illustrated operations may be required to implement the method 200 in accordance with the disclosed subject matter. In addition, those skilled in the art will understand and appreciate that the method 200 could alternatively be represented as a series of interrelated states via a state diagram or events.

In some embodiments, one or more machine learning models may be generated and trained by the artificial intelligence engine and/or the training engine to perform one or more of the operations of the methods described herein. For example, to perform the one or more operations, the processing device may execute the one or more machine learning models. In some embodiments, the one or more machine learning models may be iteratively retrained to select different features capable of enabling optimization of output. The features that may be modified may include a number of nodes included in each layer of the machine learning models, an objective function executed at each node, a number of layers, various weights associated with outputs of each node, and the like.

At block 202, the method 200 includes receiving, at one or more processing devices (e.g., edge and/or cloud-based), one or more measurements from one or more sensors 131 associated with a battery pack. The one or more measurements may include one or more of current, voltage, pressure, temperature, etc., or some combination thereof, optionally among other things.

At block 204, the one or more processing devices may process the one or more measurements using a data profiler to generate one or more data profiles including one or more voltage values. In some embodiments, the data profiler may be implemented in computer instructions stored on one or more memory devices and executed by one or more processing devices.

At block 206, the one or more processing devices may transform the one or more voltage values to generate one or more transformed voltage values. For example, the one or more processing devices may perform a fast Fourier transform.

At block 208, the one or more processing devices may determine, using the one or more voltage values and the one or more transformed voltage values, one or more features.

At block 210, the one or more processing devices may determine, using one or more trained edge computer-implemented models, a lithium plating occurrence prediction of the battery pack. The one or more trained edge computer-implemented models may determine the lithium plating occurrence prediction based at least on one or more uncertainties for the one or more features and one or more explanations for the one or more uncertainties. In some embodiments, the one or more explanations may pertain to the one or more features that contributed to the lithium plating occurrence prediction.

At block 212, the one or more processing devices may modify, using the lithium plating occurrence prediction, operation of the battery pack. In some embodiments, modifying operation of the battery pack may include ceasing operation of the battery pack, modifying charging of the battery pack, modifying discharging of the battery pack, causing the battery pack to consume more current or voltage, or causing the battery pack to consume less current or voltage.

In some embodiments, the one or more processing devices may resample the one or more voltage values using an averaging zone to generate one or more resampled voltage values. A size of the averaging zone may be determined based on available computational power.

In some embodiments, the one or more processing devices may transmit, to a cloud-based computing system 116, the one or more features, the one or more uncertainties, the one or more explanations, or some combination thereof to cause the cloud-based computing system 116 to retrain one or more cloud-based computer-implemented models that predict lithium plating.

In some embodiments, one or more parameters used to train the one or more trained edge computer-implemented models may be received from a cloud-based computing system 116 executing an explainable boosting machine that employs bagging and gradient boosting to learn each feature function and automatically identifies and incorporates combined feature terms.

In some embodiments, the cloud-based computing system 116 may identify at least one feature of the one or more features having an uncertainty that exceeds a threshold and removes the at least one feature.

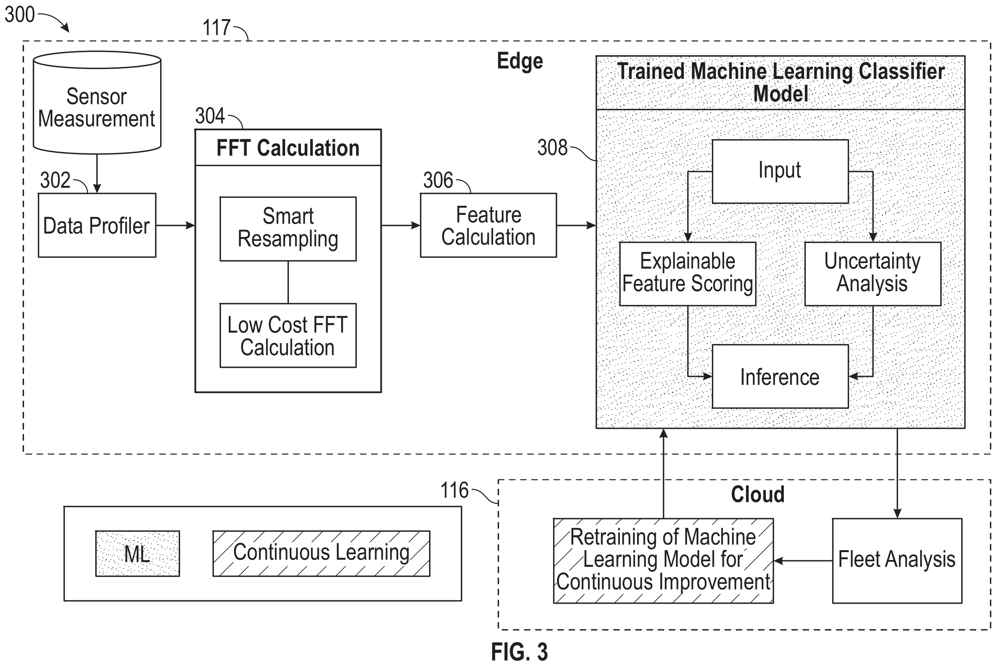

FIGURE 3 illustrates an example architecture 300 of using one or more computer-implemented models 132 to predict one or more occurrences of lithium plating and performing one or more actions according to certain embodiments of this disclosure. In some embodiments, sensor measurements may be obtained by the sensors 131 and the sensor measurements may include sensory data such as battery cell voltage, current, and temperature.

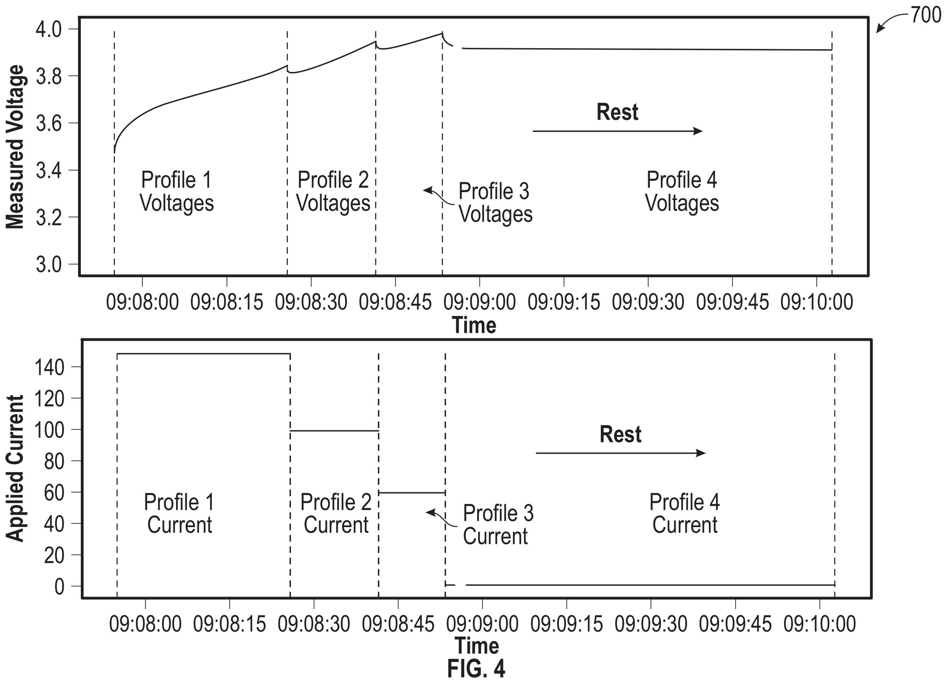

A data profiler 302 may be executed via one or more edge processing devices. The data profiler 302 may divide the sensor measurement data into separate profiles using the current values at a certain time, e.g., as shown in FIGURE 4. Then, the voltage values during each current profile may be extracted and used for calculations and/or transformations.

At 304, the one or more edge processing devices may perform a fast Fourier transform. The incoming voltage data from the data profiler 302 may be intelligently resampled in order to increase the speed of fast Fourier transform calculations by orders of magnitude. This low cost fast Fourier transform calculation / transformation may enable the detection and prevention of lithium plating on low powered chips. Accordingly, in some embodiments, the disclosed technique provide a technical solution to a technical problem of detecting lithium plating using low powered chips.

At 306, the one or more edge processing devices may perform feature calculation. The features input to the computer-implemented model 132 (trained machine learning classifier model 308) may be calculated with data coming from the data profiler 302 and fast Fourier transform calculation 304. As such, in some examples, determining the one or more features may include selecting from a plurality of profiles and/or a plurality of frequency-domain profiles.

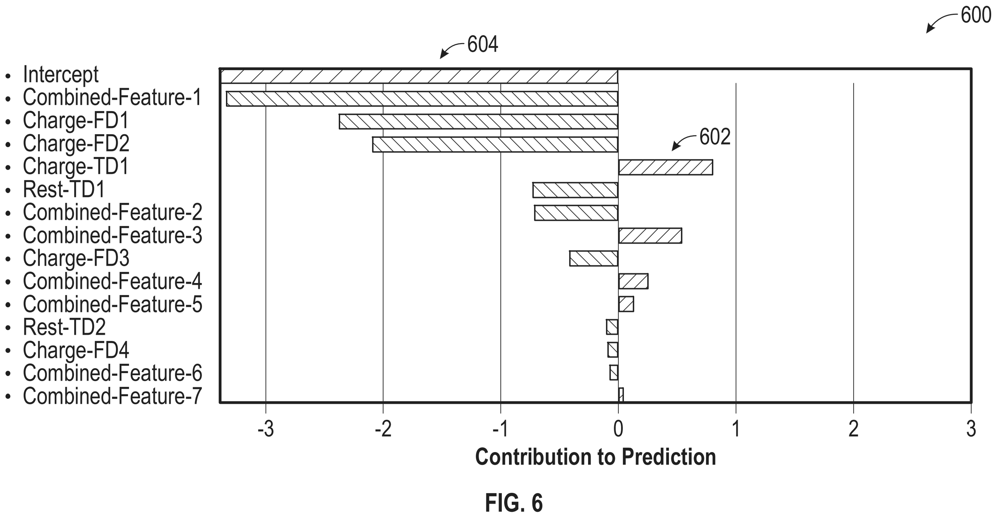

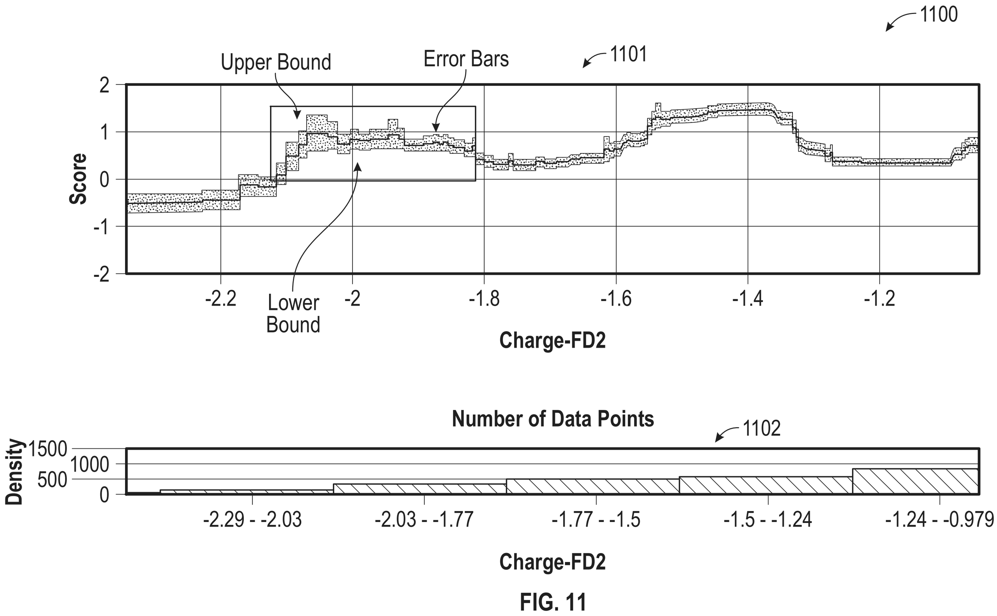

The trained machine learning classifier model 308 may receive the features calculated during the feature calculation 306 step to perform an inference. The trained machine learning classifier model 308 may generate uncertainty for each feature, as explained further below with reference to FIGURE 11, and may provide explainability for each feature that contributed most to a final prediction, as explained further below with reference to FIGURE 6. In some examples, an uncertainty value for each feature represents, or is associated with, the quantity of training data for that feature that the model was trained with. As an example, an explainability score for each feature represents the degree of influence that feature has on the overall prediction of lithium plating output by the model, e.g. by comparing the output with that feature to output with identical inputs except that feature is absent, or by learning from historic data. A feature with a high explainability score indicates that that feature makes a large contribution to the prediction of lithium plating, e.g. the feature largest explainability score represents the feature that could be modified in operation of a battery pack to most reduce the likelihood of lithium plating.

As depicted, in the cloud-based computing system 116, one or more servers 128 may perform fleet analysis. Fleet analysis may use the inference, uncertainty, and explainability data from the edge processing devices to modify a charging type (e.g., speed, maximum charging current, etc.) and control a charger control unit.

Further, the cloud-based computing system 116 may retrain the one or more computer-implemented models 132 and the parameters of the retrained computer-implemented models 132 may be transmitted to the edge 117 for implementation in the trained machine learning classifier model 308 and/or any other computer-implemented model 132 executed by the edge processing devices. The cloud-based computing system 116 may use the data from the fleet analysis to retrain the computer-implemented models 132 to increase their performance.

FIGURE 4 illustrates profile example graphs 700 of voltage and current according to certain embodiments of this disclosure. In some embodiments, the sensor measurement data may be divided into separate profiles using the current value at that time (i.e. the value of electrical current at that time). Then, the voltage values during each current profile may be extracted and used for fast Fourier transform calculation. Data may be extracted during charging (e.g., using sensors 131). In some embodiments, the techniques may apply to CCCV (Constant Current Constant Voltage), Multi-Stage CCCV (Constant Current Constant Voltage), and CC (Constant Current) Charging methods. In some embodiments, the techniques disclosed herein may be used with discharging.

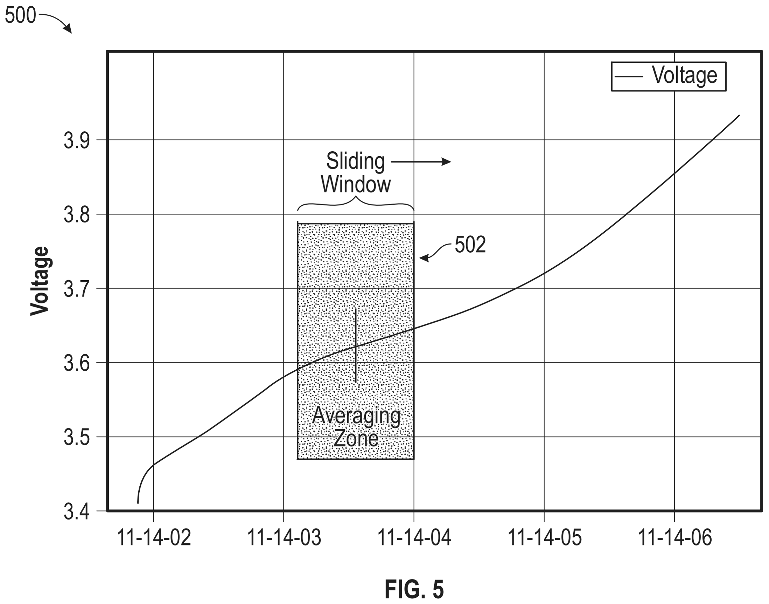

FIGURE 5 illustrates an example of a sampling process 500 according to certain embodiments of this disclosure. In some embodiments, the entirety of a profile event (charge/rest) may be input into a feature generation pipeline. This pipeline may leverage fast Fourier transform in order to extract and capture information that can be related to lithium plating. However, fast Fourier transform task may be computationally heavy and it may be very difficult to run on low powered chips which are heavily constrained by processing and memory limits.

In some embodiments, a technical solution may include resampling data to enable using low powered processing chips. However, the valuable information from original high frequency signal must be preserved during resampling. Thus, in some embodiments, the disclosed techniques may use a predetermined averaging zone 502 where right and left data points of that interval may be equally away from the middle point. This averaging zone 502 may be dependent of the original signal sampling rate and its intervals changes with different data sources. The averaging zone 502 window size may be determined by available computational power. Both charging and rest profiles may use the same sampling parameters. In some embodiments, the processing devices may slide this averaging zone 502 over the entire profile signal in order to resample it without losing valuable information from the original signal. In some embodiments, the disclosed embodiments may enable reducing the memory requirements for processing this signal up to 150 times, in some scenarios. This enables using millions of Li-Ion battery powered devices that the disclosed techniques may be executed on efficiently and to save computing resources.

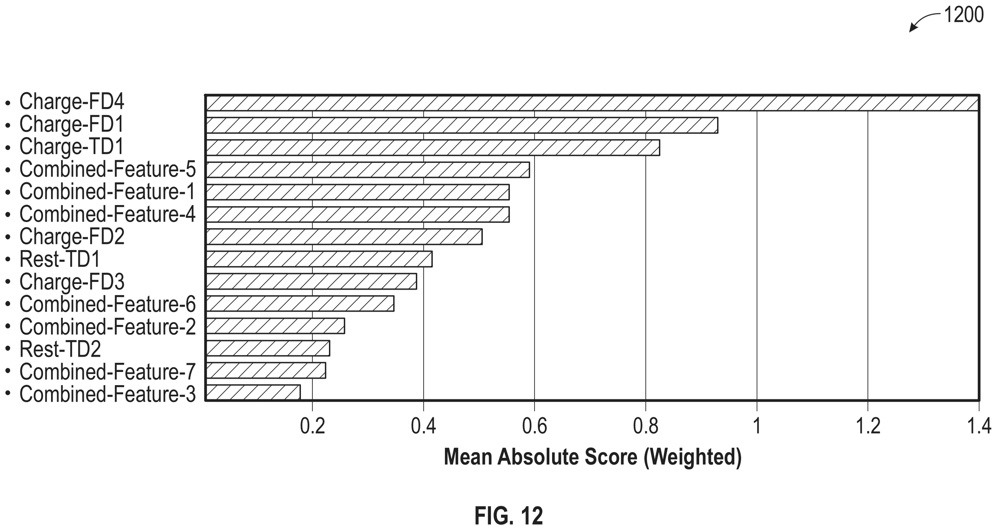

In some embodiments, the disclosed techniques may use at least 7 features extracted from 2 different profile groups and 2 different domains. In some examples, the number of features to be used is determined based on the available processing power. In some examples, the features are chosen in order starting with the feature having the most impact on lithium plating (as explained below with reference to FIGURE 12), the second most, and then so on until the chosen number of features to be used is reached. Typical domains are:
- Charging
   o Time Domain
   o Frequency Domain
- Rest After Charging
   o Time Domain
Typical features are labelled TD and FD for Time Domain and Frequency Domain. They are further labelled for charging as Charge-TDx, Charge-FDx, Rest-TDx, where x is the number of the feature (e.g. voltage profile or transformed voltage profile) and label Charge denotes Charging cycle and Rest denotes the rest period following the charging cycle. Typical group of features:
- Time Domain Features :
   o Charge-TD1
- Frequency Domain Features:
   o Charge-FD1
   o Charge-FD2
   o Charge-FD3
   o Charge-FD4
- Rest After Charging Feature Group, Time Domain Features :
   o Rest-TD1
   o Rest-TD2

However, these numbers of features, different profile groups, and different domains should not limit the scope of the disclosure. In some embodiments, the features may be selected from a pool using feature elimination. An original feature pool for both charge and rest phases may span through TD1-TDx, FD1-FDx. Those groups and domains may include charging, time domain, frequency domain, rest after charging, and/or time domain. In some embodiments, the features may include a charging feature group, such as time domain features (charge-TD1) and frequency domain features (charge-FD1, charge-FD2, charge-FD3, charge-FD4). In some embodiments, the features may include a rest after charging feature group, such as time domain features (rest-TD1, rest-TD2).

During the inference phase, each feature may contribute to a final prediction by a score. In some embodiments, a sum of those scores will be input into a function (e.g., sigmoid function reproduced below) in order to generate the final prediction score. $f \left(x\right) = \frac{1}{1 + {e}^{- x}}$

For example, imagine the features receive the following scores:
Intercept : -3.4
Combined-Feature-1 : -3.2
Charge-FD1 : -2.2
Charge-FD2 : -2.05
Charge-TD1 : 0.8
Rest-TD1 : -0.7
Combined-Feature-2 : -0.65
Combined-Feature-3 : 0.55
Charge-FD3 : -0.45
Combined-Feature-4 : 0.2
Combined-Feature-5 : 0.1
Rest-TD2 : -0.07
Charge-FD4 : -0.06
Combined-Feature-6 : -0.05
Combined-Feature-7 : 0.01

If all of the above scores are summed, the result equals -11.17. In some embodiments, the processing device may input this score into the sigmoid function as x and find that the probability of this cell being lithium plated is less than 0.1 percent, which indicates that this cell is healthy. If the probability is above a threshold (e.g., 50 percent), the processing device executing one or more computer-implemented models 132 may identify this cell as lithium plated.

FIGURE 6 illustrates an example graph 600 of individual score contributions of each feature according to certain embodiments of this disclosure. In some embodiments, an explainable boosting machine's (EBM) glass-box model (e.g., computer-implemented models 132) may identify one or more reasons of a prediction. In some embodiments, the one or more processing devices may modulate charging using the explanation data generated using the explainable boosting machine.

In some embodiments, one or more computer-implemented models 132 may investigate a contribution of each feature (and their combination) to a prediction and execute an action pertaining to charging of the battery pack in order to prevent and/or inhibit lithium plating. A combination feature represents the combined occurrence of two (or more) features, e.g., a combination of a first voltage profile and a second voltage profile. This captures the way that two different profiles may have a non-linear effect of the likelihood of lithium plating. As an example, the combination feature of a voltage profile representing rapid charge event followed by a voltage profile representing a rest might contribute to the lithium plating prediction differently to the combination feature of the voltage profile representing the rapid charge event followed by a voltage profile representing a rapid discharge event.

In FIGURE 6, the positively scored features 602 may contribute to the formation of lithium plating. The negatively scored features 604 may not contribute to the formation of lithium plating. In some embodiments, both singular and combined features are explainable using the disclosed techniques. Any type of feature may be selected for processing to predict lithium plating.

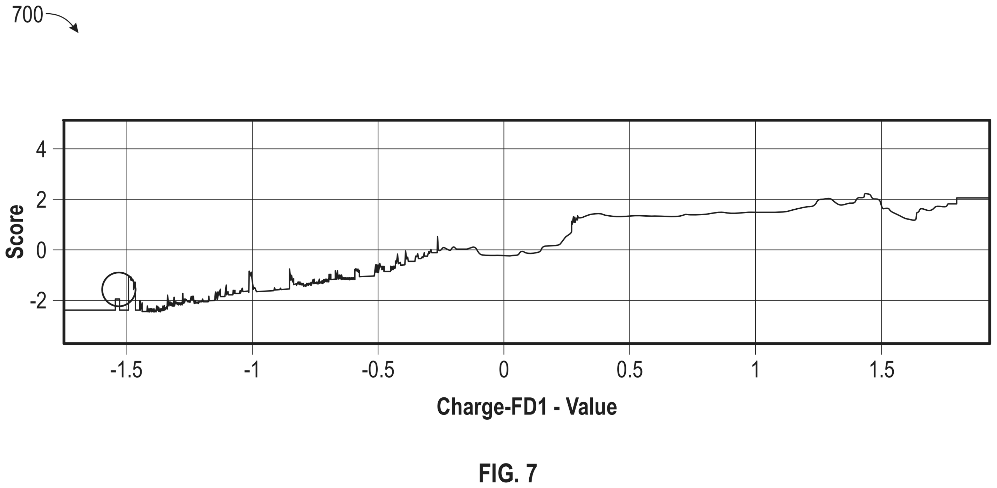

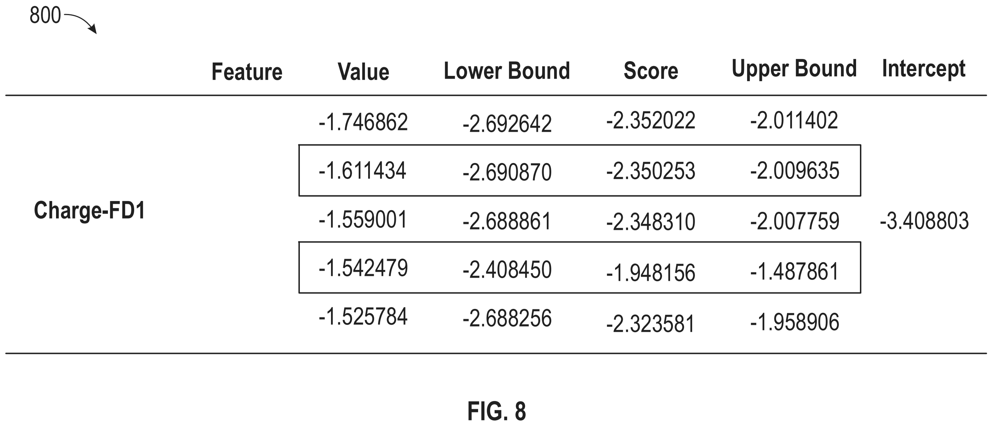

FIGURE 7 illustrates a value verse score graph 700 of an example feature according to certain embodiments of this disclosure. For example, the feature value 1 corresponds to a score of -1.8. Positive scores may indicate that a battery cell is more likely to have lithium plating, and negative scores may indicate that the battery cell is more likely to be healthy. The scores are learned by the computer-implemented models 132 during a computer-implemented model training phase. The scores in each of FIGURE 8 to FIGURE 11 are also the score representing a probability of lithium plating, which is the primary output of the one or more trained edge computer-implemented models.

FIGURE 8 illustrates a value verse score table 800 of an example feature according to certain embodiments of this disclosure. Lower and Upper Bound indicate what the score could be due to uncertainty of the computer-implemented model 132 (e.g., (trained machine learning classifier model 308, EBM, glass-box model). Intercept is inherent characteristics of the computer-implemented model, which may be added to the summation of the scores at the final prediction step. In some embodiments, since it reflects the characteristics of the computer-implemented model, it only has one value for the entire model.

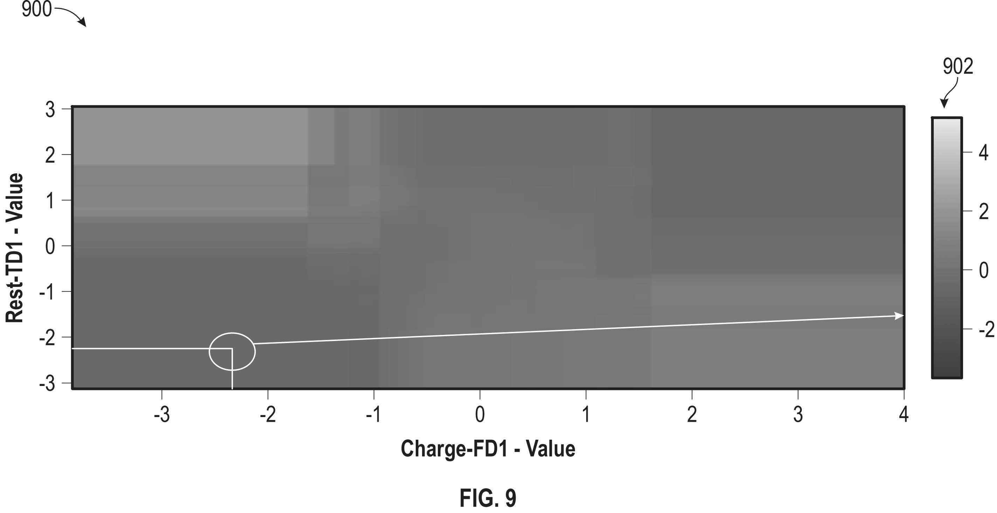

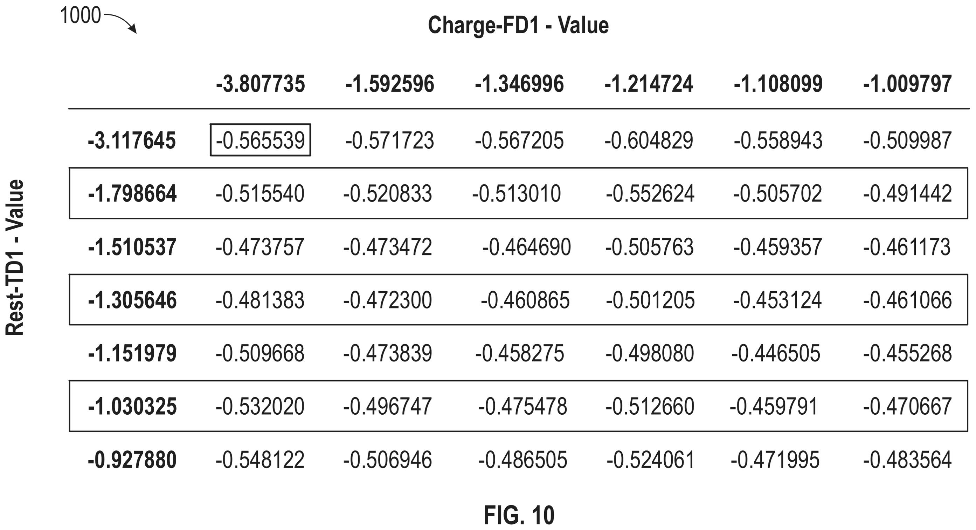

FIGURE 9 illustrates a value verse score graph 900 of example combined features according to certain embodiments of this disclosure. Similar to singular feature scoring described above, combination score may be determined by the intersection of 2 feature values. The scores may be learned during the computer-implemented model training phase. An example score table 1000 is illustrated in FIGURE 10. In FIGURE 9, consider the circled point in the graph, area values are below
Charge-FD1-Value is between -3.807735 & -1.592596 and
Rest-TD1-Value is between -3.117645 & -1.798664

The score of the combined features is shown on right side score bar 902 of FIGURE 9 and is -0.565539, which is indicative of the battery cell and/or battery pack not having lithium plating occurrence.

FIGURE 11 illustrates charts 1100 representing density and score verse value for an example feature according to certain embodiments of this disclosure. For each feature, there are some feature values that have high uncertainty, and those may be used during training to increase the precision robustness of the computer-implemented models 132 used herein. In some embodiments, uncertainty data (e.g., plot) is combined with explainability data in order to detect what might have caused this uncertainty and the processing device may perform an action to fix the issue at the source (e.g. charging).

The size of the error bar in FIGURE 11 may be determined by two main factors: the quantity of training data available in that part of the feature space, and the inherent uncertainty of the model that has been learned. As an illustration, consider graph 1101 displaying the 'Charge-FD2' feature learned from the dataset. Towards the left side of the graph 1101, the predictions of the computer-implemented model 132 model start to become unstable, leading to larger error bars that signify increased uncertainty. The density graph 1102 below suggests that this instability likely stems from the limited number of samples in this specific area.

The error estimates may be generated using bagging for each feature. Bagging may refer to bootstrap aggregating, which is a type of ensemble learning that combines multiple models trained on different subsets of data. Multiple random subsets of the dataset are created. This means that some data points may appear multiple times in a subset, while others may be left out. By default, explainable boosting machines (EBMs) train multiple mini-EBMs on random percentage (e.g., 85 percent) subsets of the training data. The results of these models may be averaged to produce the final EBM, and the standard deviation of estimates for each region on the graph is presented as the error bar. EBM, through uncertainty analysis allows selections of features that are less prone to errors.

In some cases, gradient boosting may be used for better error reduction. Gradient Boosting is an ensemble learning technique that builds a strong model by combining multiple weak models, typically decision trees in a sequential manner. Gradient boosting learns from previous mistakes by minimizing errors step by step. Below equation demonstrates gradient boosting mathematically ${r}_{m} = - \partial L \left(y,F\left(x\right)\right) / \partial F \left(x\right)$ where rₘ is the negative residual representing the difference between the actual value and the model's predicted value, ∂ denotes derivative, L(y,F(x)) is the Loss function and F(x) is the models prediction.

The EBM may refer to a type of tree-based, cyclic gradient boosting generalized additive model [GAM] that automatically detects interactions. EBMs may match the accuracy of advanced black box models while maintaining full interpretability. A GAM may refer to a statistical model that combines the flexibility of non-parametric models with the interpretability of linear models.

In the EBM, the intercept may represent the global bias or baseline prediction of the computer-implemented model 132 before considering any of the individual rules or features. It may be interpreted as a starting point or initial prediction that the computer-implemented model 132 makes in the absence of any specific information about the input features.

The disclosed EBM may introduce several key advancements such as employing machine learning methods like bagging and gradient boosting to learn feature function. Also, EBM may have the capability to automatically identify and incorporate combining features terms. ${{g \left(E\left[y\right]\right)}_{︸}}_{\begin{matrix}Final \\ Score\end{matrix}} = {{{β}_{0}}_{︸}}_{Intercept} + {{\sum {f}_{i} \left({x}_{i}\right)}_{︸}}_{\begin{matrix}Individual \\ Feature\end{matrix}} + {{\sum {f}_{i , j} \left({x}_{i}, {x}_{j}\right)}_{︸}}_{\begin{matrix}Combination \\ Features\end{matrix}}$

To generate individual predictions, each function may operate as a lookup table for each feature, returning a term contribution. By examining the variability of these contributions across different bagged models, EBM may estimate the uncertainty for each feature. These contributions may be added together and processed through a link function to produce the final prediction. Link function transforms EBM output into a probability: $P \left(y=1,x\right) = \frac{1}{1 + {e}^{- f \left(x\right)}}$ where P is probability, y is target variable and x is input data. Due to the computer-implemented model's modularity (additivity), these term contributions can be ranked and visualized to highlight which features had the greatest influence on a particular prediction, as depicted in FIGURE 12. This process helps in visualizing and understanding which features have the most stable and impactful contributions to the model's predictions. In FIGURE 12, the mean absolute score (weighted) is an example of a feature impact score, also referred to as an explainability score, which represents a degree of influence the respective feature has on the output of the model, i.e. on the prediction of lithium plating.

A method called FAST may be implemented to rank all possible pairs of features based on the strength of their interactions. FAST (Feature Allocation Selection Technique) is an optimization technique used in Explainable Boosting Machines (EBMs) to efficiently identify and allocate interactions between features while maintaining model interpretability. FAST first identifies promising feature pairs by analyzing individual feature importance scores. Instead of brute-force searching all feature pairs, FAST prioritizes only high-impact interactions. EBM may internally generate the best features using FAST method. This may be performed by evaluating the reduction in residual sum of squares (RSS) when adding a pairwise interaction term to the model. RSS may be used to quantify the strength of interactions between pairs of features, with lower RSS values indicating stronger interactions because they show less discrepancy between the predicted and actual values when the interaction is considered. The pairs that result in the most significant reduction in RSS may be considered the strongest interactions and used as combination features, in some embodiments.

To continuously improve the performance of the computer-implemented model 132, retraining may be performed with specific intervals (e.g., daily, monthly, bi-monthly, etc.). For each dataset, a recursive feature elimination specifically tuned to EBM may be performed. Such a technique may reduce false positives and further simplify the computer-implemented model 132 because less features may equate to reduced computational load.

In some embodiments, a test dataset which contains confirmed cases of lithium plating may be used. A feature pool from 2 different profile groups (charge and rest) and 2 different domains (time and frequency) may be used. The feature pool for both charge and rest phases spans through TD1-TDx, FD1-FDx. In some embodiments, the processing device may recursively reduce the number of available features one-by-one and observe the performance of the computer-implemented model 132 on that test dataset. In some embodiments, the processing device execute an algorithm to remove the feature that is the most harmful for the results over the test dataset. The algorithm may repeat these steps until the improvement over the test dataset stops.

Example:
(a) Initial Feature Pool: TD1, TD2, .. TDX, FD1, FD2, ... FDx
(b) Initial Model Performance: 95%
(c) Step-by-Step Process
   i. Iteration 1:
      1. Feature Removal
         a. Remove TD1: Model Performance = 94%
         b. Remove TD2: Model Performance = 96%
         c. .
         d. .
         e. .
         f. Remove TDx: Model Performance = 95%
         g. Remove FD1: Model Performance = 95%
         h. .
         i. .
         j. Remove FDx: Model Performance = 95%
      2. Best Performance Improvement: Removing TD2 increased performance to 96%.
      3. Update: Remove TD2 from Feature Pool.
   ii. Iteration 2:
      1. New Feature Pool: TD1, .. TDx, FD1, FD2, ... FDx
      2. Best Performance: 96%
      3. Feature Removal
         a. Remove TD1: Model Performance = 94%
         b..
         c. .
         d. Remove TDx: Model Performance = 96%
         e. Remove FD1: Model Performance = 95%
         f. .
         g. .
         h. Remove FDX: Model Performance = 96%
      4. Best Performance Improvement: No feature removal improves performance further.
(d) Final Features: TD1, .. TDx, FD1, FD2, ... FDx

In some embodiments, the disclosed techniques may provide explainability using glass-box models by identifying reasons of predictions using EBMs. The processing device may modulate charging using the information from the explanation data and retrain the computer-implemented models 132 for higher accuracy predictions.

Further, some embodiments may perform uncertainty analysis. For each feature, the processing device may find and remove high uncertainty features to increase precision robustness of our model. Some embodiments, combine uncertainty with explainability, in order to detect what might have caused this uncertainty and correct it on the source (e.g. change charging profile to prevent lithium plating).

For example, in FIGURE 11, the portions of score table where it has a big error bar also has low data density, it is possible to modify charging to gather more data in low density zones in order to decrease uncertainty of the computer-implemented model 132 and make predictions with greater accuracy to detect and prevent lithium plating.

Further, in some embodiments, intelligent sampling may be performed to resample the signal in order to achieve significant reduction in input signal size and make fast Fourier transformations accessible on multiple battery cells at the same time on computationally less powerful processing chips. This makes it possible to execute the disclosed techniques on more devices that runs on Li-Ion batteries.

In addition, in some embodiments, recursive feature elimination may be performed. The processing device may use recursive feature elimination tailored specifically for EBM, glass-box model in order to remove features. This may lead to a small footprint on memory devices (easier calculation) and reduced false positives. Also, in some embodiments, the computer-implemented models 132 may be retrained for higher accuracy with new features.

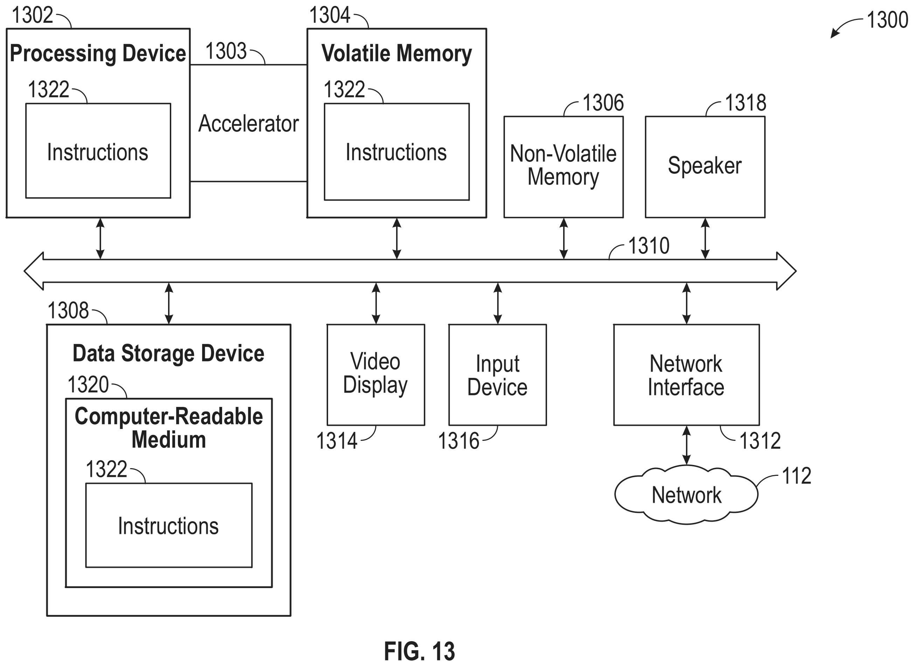

FIGURE 13 illustrates example computer system 1300 which can perform any one or more of the methods described herein, in accordance with one or more aspects of the present disclosure. In one example, computer system 1300 may correspond to the computing device 102 (e.g., user computing device), one or more servers 128 of the cloud-based computing system 116, the training engine 130, any component of the vehicle 117, the artificial intelligence engine 140 of the cloud-based computing system 116, the one or more computer-implemented models 132 of the cloud-based computing system 116, or any suitable component of FIGURE 1. The computer system 1300 may be capable of executing the one or more computer-implemented models 132 of FIGURE 1. The computer system may be connected (e.g., networked) to other computer systems in a LAN, an intranet, an extranet, or the Internet. The computer system may operate in the capacity of a server in a client-server network environment. The computer system may be a personal computer (PC), a tablet computer, a wearable (e.g., wristband), a set-top box (STB), a personal Digital Assistant (PDA), a mobile phone, a camera, a video camera, or any device capable of executing a set of instructions (sequential or otherwise) that specify actions to be taken by that device. Further, while only a single computer system is illustrated, the term "computer" shall also be taken to include any collection of computers that individually or jointly execute a set (or multiple sets) of instructions to perform any one or more of the methods discussed herein.

The computer system 1300 includes a processing device 1302, a volatile memory 1304 (e.g., random access memory (RAM)), a non-volatile memory 1306 (e.g., read-only memory (ROM), flash memory, solid state drives (SSDs), and a data storage device 1308, the foregoing of which are enabled to communicate with each other via a bus 1310.

Processing device 1302 represents one or more general-purpose processing devices such as a microprocessor, central processing unit, or the like. More particularly, the processing device 1302 may be a complex instruction set computing (CISC) microprocessor, reduced instruction set computing (RISC) microprocessor, very long instruction word (VLIW) microprocessor, or a processor implementing other instruction sets or processors implementing a combination of instruction sets. The processing device 1302 may also be one or more special-purpose processing devices such as an application specific integrated circuit (ASIC), a system on a chip, a field programmable gate array (FPGA), a digital signal processor (DSP), network processor, or the like. The processing device 1302 may include more than one processing device, and each of the processing devices may be the same or different types. The processing device 1302 may include or be communicatively coupled to one or more accelerators 1303 configured to offload various data-processing tasks from the processing device 1302. The processing device 1302 is configured to execute instructions for performing any of the operations and steps discussed herein.

The computer system 1300 may further include a network interface device 1312. The network interface device 1312 may be configured to communicate data via any suitable communication protocol. In some embodiments, the network interface devices 1312 may enable wireless (e.g., WiFi, Bluetooth, ZigBee, etc.) or wired (e.g., Ethernet, etc.) communications. The computer system 1300 also may include a video display 1314 (e.g., a liquid crystal display (LCD), a light-emitting diode (LED), an organic light-emitting diode (OLED), a quantum LED, a cathode ray tube (CRT), a shadow mask CRT, an aperture grille CRT, or a monochrome CRT), one or more input devices 1316 (e.g., a keyboard or a mouse), and one or more speakers 1318 (e.g., a speaker). In one illustrative example, the video display 1314 and the input device(s) 1316 may be combined into a single component or device (e.g., an LCD touch screen).

The output device 1350 may transmit and receive data from a computer system application programming interface (API). The data may pertain to any suitable information described herein, such as a remaining useful life of a battery pack, among other information.

The data storage device 1308 may include a computer-readable medium 1320 on which the instructions 1322 embodying any one or more of the methods, operations, or functions described herein is stored. The instructions 1322 may also reside, completely or at least partially, within the volatile memory 1304 or within the processing device 1302 during execution thereof by the computer system 1300. As such, the volatile memory 1304 and the processing device 1302 also constitute computer-readable media. The instructions 1322 may further be transmitted or received over a network via the network interface device 1312.

While the computer-readable storage medium 1320 is shown in the illustrative examples to be a single medium, the term "computer-readable storage medium" should be taken to include a single medium or multiple media (e.g., a centralized or distributed database, or associated caches and servers) that store the one or more sets of instructions. The term "computer-readable storage medium" shall also be taken to include any medium capable of storing, encoding, or carrying a set of instructions for execution by the machine, where such set of instructions cause the machine to perform any one or more of the methodologies of the present disclosure. The term "computer-readable storage medium" shall accordingly be taken to include, but not be limited to, solid-state memories, optical media, and magnetic media.

None of the description in this application should be read as implying that any particular element, step, or function is an essential element that must be included in the claim scope. The scope of patented subject matter is defined only by the claims. Moreover, none of the claims is intended to invoke 35 U.S.C. § 112(f) unless the exact words "means for" are followed by a participle.

Consistent with the above disclosure, the examples of systems and method enumerated in the following clauses are specifically contemplated and are intended as a nonlimiting set of examples.
1. A computer-implemented method comprising:
   receiving, at one or more edge processing devices, one or more measurements from one or more sensors associated with a battery pack;
   processing, at the one or more edge processing devices, the one or more measurements using a data profiler to generate one or more data profiles comprising one or more voltage values;
   transforming, at the one or more edge processing devices, the one or more voltage values to generate one or more transformed voltage values;
   determining, at the one or more edge processing devices using the one or more voltage values and the one or more transformed voltage values, one or more features;
   determining, using one or more trained edge computer-implemented models, a lithium plating occurrence prediction of the battery pack, wherein the one or more trained edge computer-implemented models determines the lithium plating occurrence prediction based at least on one or more uncertainties for the one or more features and one or more explanations for the one or more uncertainties; and
   modifying, using the lithium plating occurrence prediction, operation of the battery pack.
2. A computer-implemented method comprising:
   receiving, at one or more edge processing devices, one or more measurements from one or more sensors associated with a battery pack;
   processing, at the one or more edge processing devices, the one or more measurements using a data profiler to generate one or more data profiles comprising one or more voltage values;
   transforming, at the one or more edge processing devices, the one or more voltage values to generate one or more transformed voltage values;
   determining, at the one or more edge processing devices using the one or more voltage values and the one or more transformed voltage values, one or more features;
   determining, using one or more trained edge computer-implemented models, a lithium plating occurrence prediction of the battery pack, wherein the one or more trained edge computer-implemented models determines the lithium plating occurrence prediction based at least on the one or more features; and
   modifying, using the lithium plating occurrence prediction, operation of the battery pack.
3. The computer-implemented method of clause 2, wherein the one or more trained edge computer-implemented models determines the lithium plating occurrence prediction based at least on one or more uncertainties for the one or more features and one or more explanations for the one or more uncertainties.
4. The computer-implemented method of clauses 1 or 3, wherein the one or more uncertainties each relate to a respective feature of the one or more features, wherein the uncertainty for the respective feature depends on a quantity of training data for the respective feature used to train the one or more trained edge computer-implemented models.
5. The computer-implemented method of any of clauses 1, 3, or 4, wherein the one or more explanations each relate to a respective feature of the one or more features, wherein the explanation for the respective feature represents a degree of influence the respective feature has on the prediction of lithium plating.
6. The computer-implemented method of any of clauses 1, 3, 4, or 5, wherein the one or more explanations is one or more explainability scores.
7. The computer-implemented method of clause 6, wherein the one or more features are determined based on the explainability scores of the one or more features in order from most influence on lithium plating to least.
8. The computer-implemented method of clause 6, wherein the determining determines a number of features, wherein the number of features is determined by available edge-processing power, wherein the one or more features are determined based on the explainability scores of the one or more features in order from most influence on lithium plating to least until the number of features is reached.
9. The computer-implemented method of any clause herein, further comprising resampling, at the one or more edge processing devices, the one or more voltage values using an averaging zone to generate one or more resampled voltage values, wherein a size of the averaging zone is determined based on available computational power.
10. The computer-implemented method of any clause herein, further comprising transmitting, to a cloud-based computing system, the one or more features, the one or more uncertainties, the one or more explanations, or some combination thereof to cause the cloud-based computing system to retrain one or more cloud computer-implemented models that predict lithium plating.
11. The computer-implemented method of any clause herein, wherein one or more parameters used to train the one or more trained edge computer-implemented models are received from a cloud-based computing system executing an explainable boosting machine that employs bagging and gradient boosting to learn each feature function and automatically identifies and incorporates combined feature terms.
12. The computer-implemented method of any clause herein, wherein a cloud-based computing system identifies at least one feature of the one or more features having an uncertainty that exceeds a threshold and removes the at least one feature.
13. The computer-implemented method of any clause herein, wherein modifying operation of the battery pack further comprises ceasing operation of the battery back, modifying charging of the battery pack, modifying discharging of the battery pack, causing the battery pack to consume more current or voltage, or causing the battery pack to consume less current or voltage.
14. The computer-implemented method of any clause herein, wherein the one or more explanations pertains to the one or more features that contributed to the lithium plating occurrence prediction.
15. The computer-implemented method of any clause herein, wherein the transforming uses a fast Fourier transform to generate the one or more transformed voltage values.
16. The computer-implemented method of any clause herein, wherein the one or more features includes at least one feature from a charging period and at least one feature from a rest after charging period.
17. The computer-implemented method of any clause herein, wherein the data profiler divides the one or more measurements into a plurality of profiles based on current measurements, wherein each profile of the plurality of profiles comprises voltage measurements over a respective period of time.
18. The computer-implemented method of clause 17, wherein each profile of the plurality of profiles is defined by a respective period of constant current.
19. The computer-implemented method of any clause herein, wherein the transforming transforms the plurality of profiles into a plurality of frequency-domain profiles.
20. The computer-implemented method of any of clauses 17 to 19, wherein determining the one or more features includes selecting from the plurality of profiles and/or the plurality of frequency-domain profiles.
21. The computer-implemented method of any of clauses 17 to 20, wherein the one or more features includes a combination feature, wherein the combination feature represents an occurrence of two or more of the plurality of profiles.
22. The computer-implemented method of any of clauses 17 to 21, wherein the one or more features includes at least one of the plurality of profiles and at least one of the plurality of frequency-domain profiles.
23. The computer-implemented method of any of clauses 16 to 22 or any clause herein, wherein the one or more features includes: a first profile from the charging period; a first frequency-domain profile from the charging period; a second frequency-domain profile from the charging period; a third frequency-domain profile from the charging period; a fourth frequency-domain profile from the charging period; a second profile from the rest after charging period; and a third profile from the rest after charging period.
24. A computer-readable medium storing instructions that, when executed, cause a processing device to:
   receive, at one or more edge processing devices, one or more measurements from one or more sensors associated with a battery pack;
   process, at the one or more edge processing devices, the one or more measurements using a data profiler to generate one or more data profiles comprising one or more voltage values;
   transform, at the one or more edge processing devices, the one or more voltage values to generate one or more transformed voltage values;
   determine, at the one or more edge processing devices using the one or more voltage values and the one or more transformed voltage values, one or more features;
   determine, using one or more trained edge computer-implemented models, a lithium plating occurrence prediction of the battery pack, wherein the one or more trained edge computer-implemented models determines the lithium plating occurrence prediction based at least on the one or more features; and
   modify, using the lithium plating occurrence prediction, operation of the battery pack.
25. The computer-readable medium of any clause herein, further comprising resampling, at the one or more edge processing devices, the one or more voltage values using an averaging zone to generate one or more resampled voltage values, wherein a size of the averaging zone is determined based on available computational power.
26. The computer-readable medium of any clause herein, further comprising transmitting, to a cloud-based computing system, the one or more features, the one or more uncertainties, the one or more explanations, or some combination thereof to cause the cloud-based computing system to retrain one or more cloud computer-implemented models that predict lithium plating.
27. The computer-readable medium of any clause herein, wherein one or more parameters used to train the one or more trained edge computer-implemented models are received from a cloud-based computing system executing an explainable boosting machine that employs bagging and gradient boosting to learn each feature function and automatically identifies and incorporates combined feature terms.
28. The computer-readable medium of any clause herein, wherein a cloud-based computing system identifies at least one feature of the one or more features having an uncertainty that exceeds a threshold and removes the at least one feature.
29. The computer-readable medium of any clause herein, wherein modifying operation of the battery pack further comprises ceasing operation of the battery back, modifying charging of the battery pack, modifying discharging of the battery pack, causing the battery pack to consume more current or voltage, or causing the battery pack to consume less current or voltage.
30. The computer-readable medium of any clause herein, wherein the one or more explanations pertains to the one or more features that contributed to the lithium plating occurrence prediction.
31. The computer-readable medium of any clause herein, wherein the computer-readable medium is tangible and non-transitory.
32. The computer-readable medium of any clause herein, wherein the one or more trained edge computer-implemented models determines the lithium plating occurrence prediction based at least on one or more uncertainties for the one or more features and one or more explanations for the one or more uncertainties.
33. A system comprising:
   one or more memory devices storing instructions; and
   one or more processing devices communicatively coupled to the one or more memory devices, wherein the one or more processing devices execute the instructions to:
      receive, at one or more edge processing devices, one or more measurements from one or more sensors associated with a battery pack;
      process, at the one or more edge processing devices, the one or more measurements using a data profiler to generate one or more data profiles comprising one or more voltage values;
      transform, at the one or more edge processing devices, the one or more voltage values to generate one or more transformed voltage values;
      determine, at the one or more edge processing devices using the one or more voltage values and the one or more transformed voltage values, one or more features;
      determine, using one or more trained edge computer-implemented models, a lithium plating occurrence prediction of the battery pack, wherein the one or more trained edge computer-implemented models determines the lithium plating occurrence prediction based at least on the one or more features; and
      modify, using the lithium plating occurrence prediction, operation of the battery pack.
34. The system of any clause herein, wherein the one or more processing devices are further to resample, at the one or more edge processing devices, the one or more voltage values using an averaging zone to generate one or more resampled voltage values, wherein a size of the averaging zone is determined based on available computational power.
35. The system of any clause herein, further comprising transmitting, to a cloud-based computing system, the one or more features, the one or more uncertainties, the one or more explanations, or some combination thereof to cause the cloud-based computing system to retrain one or more cloud computer-implemented models that predict lithium plating.
36. The system of any clause herein, wherein one or more parameters used to train the one or more trained edge computer-implemented models are received from a cloud-based computing system executing an explainable boosting machine that employs bagging and gradient boosting to learn each feature function and automatically identifies and incorporates combined feature terms.
37. The system of any clause herein, wherein a cloud-based computing system identifies at least one feature of the one or more features having an uncertainty that exceeds a threshold and removes the at least one feature.
38. The system of any clause herein, wherein the one or more explanations pertains to the one or more features that contributed to the lithium plating occurrence prediction.
39. The system of any clause herein, wherein the one or more trained edge computer-implemented models determines the lithium plating occurrence prediction based at least on one or more uncertainties for the one or more features and one or more explanations for the one or more uncertainties

## Claims

1. A computer-implemented method comprising:
receiving, at one or more edge processing devices, one or more measurements from one or more sensors associated with a battery pack;
processing, at the one or more edge processing devices, the one or more measurements using a data profiler to generate one or more data profiles comprising one or more voltage values;
transforming, at the one or more edge processing devices, the one or more voltage values to generate one or more transformed voltage values;
determining, at the one or more edge processing devices using the one or more voltage values and the one or more transformed voltage values, one or more features;
determining, using one or more trained edge computer-implemented models, a lithium plating occurrence prediction of the battery pack, wherein the one or more trained edge computer-implemented models determines the lithium plating occurrence prediction based at least on the one or more features; and
modifying, using the lithium plating occurrence prediction, operation of the battery pack.

2. The computer-implemented method of claim 1, wherein the one or more trained edge computer-implemented models determines the lithium plating occurrence prediction based at least on one or more uncertainties for the one or more features and one or more explanations for the one or more uncertainties.

3. The computer-implemented method of claim 2, wherein the one or more explanations pertains to the one or more features that contributed to the lithium plating occurrence prediction.

4. The computer-implemented method of any preceding claim, further comprising resampling, at the one or more edge processing devices, the one or more voltage values using an averaging zone to generate one or more resampled voltage values, wherein a size of the averaging zone is determined based on available computational power.

5. The computer-implemented method of any preceding claim, further comprising transmitting, to a cloud-based computing system, the one or more features, the one or more uncertainties, the one or more explanations, or some combination thereof to cause the cloud-based computing system to retrain one or more cloud computer-implemented models that predict lithium plating.

6. The computer-implemented method of any preceding claim, wherein one or more parameters used to train the one or more trained edge computer-implemented models are received from a cloud-based computing system executing an explainable boosting machine that employs bagging and gradient boosting to learn each feature function and automatically identifies and incorporates combined feature terms.

7. The computer-implemented method of any preceding claim, wherein a cloud-based computing system identifies at least one feature of the one or more features having an uncertainty that exceeds a threshold and removes the at least one feature.

8. The computer-implemented method of any preceding claim, wherein modifying operation of the battery pack further comprises ceasing operation of the battery back, modifying charging of the battery pack, modifying discharging of the battery pack, causing the battery pack to consume more current or voltage, or causing the battery pack to consume less current or voltage.

9. The computer-implemented method of any preceding claim, wherein the data profiler divides the one or more measurements into a plurality of profiles based on current measurements, wherein each profile of the plurality of profiles comprises voltage measurements over a respective period of time.

10. The computer-implemented method of claim 9, wherein the transforming transforms the plurality of profiles into a plurality of frequency-domain profiles.

11. The computer-implemented method of any claim 9 or 10, wherein determining the one or more features includes selecting from the plurality of profiles and/or the plurality of frequency-domain profiles to be the one or more features.

12. A computer-readable medium storing instructions that, when executed, cause a processing device to:
receive, at one or more edge processing devices, one or more measurements from one or more sensors associated with a battery pack;
process, at the one or more edge processing devices, the one or more measurements using a data profiler to generate one or more data profiles comprising one or more voltage values;
transform, at the one or more edge processing devices, the one or more voltage values to generate one or more transformed voltage values;
determine, at the one or more edge processing devices using the one or more voltage values and the one or more transformed voltage values, one or more features;
determine, using one or more trained edge computer-implemented models, a lithium plating occurrence prediction of the battery pack, wherein the one or more trained edge computer-implemented models determines the lithium plating occurrence prediction based at least on the one or more features; and
modify, using the lithium plating occurrence prediction, operation of the battery pack.

13. The computer-readable medium of claim 12, wherein the instructions, when executed, further cause the processing device to perform the method of any of claims 2 to 11.

14. A system comprising:
one or more memory devices storing instructions; and
one or more processing devices communicatively coupled to the one or more memory devices, wherein the one or more processing devices execute the instructions to:
receive, at one or more edge processing devices, one or more measurements from one or more sensors associated with a battery pack;
process, at the one or more edge processing devices, the one or more measurements using a data profiler to generate one or more data profiles comprising one or more voltage values;
transform, at the one or more edge processing devices, the one or more voltage values to generate one or more transformed voltage values;
determine, at the one or more edge processing devices using the one or more voltage values and the one or more transformed voltage values, one or more features;
determine, using one or more trained edge computer-implemented models, a lithium plating occurrence prediction of the battery pack, wherein the one or more trained edge computer-implemented models determines the lithium plating occurrence prediction based at least on the one or more features; and
modify, using the lithium plating occurrence prediction, operation of the battery pack.

15. The system of claim 14, wherein the one or more processing devices further execute the instructions to perform the method of any of claim 2 to 11.
